# EUROPEAN PATENT APPLICATION

(11) **EP 4 485 489 A1**
(43) Date of publication of application: **01.01.2025**
(21) Application number: 23212065.9
(22) Date of filing: 24.11.2023
(51) Int. Cl.: H01G 4/008, H01G 4/012, H01G 4/33, H01G 4/40, H10N 97/00, H01G 4/38

(54) **CARBON NANOFIBER CAPACITOR APPARATUS AND RELATED METHODS**

(30) Priority: 29.06.2023 US 202318344695
(71) Applicant: INTEL Corporation, Santa Clara, CA 95054 (US)
(72) Inventor: BRAUNISCH, Henning, 85018 Phoenix (US); ALEKSOV, Aleksandar, 85286 Chandler (US); DARMAWIKARTA, Kristof, 85249 Chandler (US); GRUJICIC, Darko, 85249 Chandler (US); WALL, Marcel, 85048 Phoenix (US); SOUNART, Thomas, 85226 Chandler (US); NAD, Suddhasattwa, 85249 Chandler (US); DUONG, Benjamin, 85044 Phoenix (US); KAVIANI, Shayan, 85048 Phoenix (US)
(74) Representative: HGF

(57) **Abstract**

Carbon nanofiber capacitor apparatus and related methods are disclosed herein. An example apparatus includes an integrated circuit package substrate, and a capacitor provided in the integrated circuit package substrate. The capacitor includes a carbon fiber array, a dielectric film positioned on the carbon fiber array, and an electrode film positioned on the dielectric film.

## Description

### FIELD OF THE DISCLOSURE

This disclosure relates generally to integrated circuit packages and, more particularly, to carbon nanofiber capacitor apparatus and related methods.

### BACKGROUND

Integrated circuit (IC) chips and/or semiconductor dies are routinely connected to larger circuit boards such as motherboards and other types of printed circuit boards (PCBs) via a package substrate. Integrated circuit (IC) chips and/or dice (e.g., dies, etc.) have exhibited reductions in size and increases in interconnect densities as technology has advanced.

### BRIEF DESCRIPTION OF THE DRAWINGS

FIG. 1 illustrates an example integrated circuit (IC) package on a printed circuit board.
FIG. 2 is a cross-sectional view of an example package substrate having a carbon nanofiber capacitor apparatus in accordance with teachings of this disclosure.
FIG. 3 is an enlarged portion of the cross-sectional view of the example package substrate and the example nanofiber capacitor apparatus of FIG. 2.
FIG. 4 is a flowchart representing an example manufacturing process for manufacturing the example package substrate and the example carbon nanofiber capacitor apparatus of FIGS. 2-3.
FIGS. 5A-5H are cross-sectional views depicting example package substrate and the example carbon nanofiber capacitor apparatus of FIGS. 2-3 in various stages of manufacturing.
FIG. 6A is a cross-sectional view of another example package substrate having another example carbon nanofiber capacitor apparatus disclosed herein.
FIG. 6B is an enlarged portion of the cross-sectional view of the example package substrate and the example nanofiber capacitor apparatus of FIG. 6A.
FIG. 7 is a top view of a wafer and dies that may be included in an IC package constructed in accordance with teachings disclosed herein.
FIG. 8 is a cross-sectional side view of an IC device that may be included in an IC package constructed in accordance with teachings disclosed herein.
FIG. 9 is a cross-sectional side view of an IC device assembly that may include an IC package constructed in accordance with teachings disclosed herein.
FIG. 10 is a block diagram of an example electrical device that may include an IC package constructed in accordance with teachings disclosed herein.

In general, the same reference numbers will be used throughout the drawing(s) and accompanying written description to refer to the same or like parts. The figures are not necessarily to scale. Instead, the thickness of the layers or regions may be enlarged in the drawings. Although the figures show layers and regions with clean lines and boundaries, some or all these lines and/or boundaries may be idealized. In reality, the boundaries and/or lines may be unobservable, blended, and/or irregular.

As used herein, unless otherwise stated, the term "above" describes the relationship of two parts relative to Earth. A first part is above a second part, if the second part has at least one part between Earth and the first part. Likewise, as used herein, a first part is "below" a second part when the first part is closer to the Earth than the second part. As noted above, a first part can be above or below a second part with one or more of: other parts therebetween, without other parts therebetween, with the first and second parts touching, or without the first and second parts being in direct contact with one another.

Notwithstanding the foregoing, in the case of referencing a semiconductor device (e.g., a transistor), a semiconductor die containing a semiconductor device, and/or an integrated circuit (IC) package containing a semiconductor die during fabrication or manufacturing, "above" is not with reference to Earth, but instead is with reference to an underlying substrate on which relevant components are fabricated, assembled, mounted, supported, or otherwise provided. Thus, as used herein and unless otherwise stated or implied from the context, a first component within a semiconductor die (e.g., a transistor or other semiconductor device) is "above" a second component within the semiconductor die when the first component is farther away from a substrate (e.g., a semiconductor wafer) during fabrication/manufacturing than the second component on which the two components are fabricated or otherwise provided. Similarly, unless otherwise stated or implied from the context, a first component within an IC package (e.g., a semiconductor die) is "above" a second component within the IC package during fabrication when the first component is farther away from a printed circuit board (PCB) to which the IC package is to be mounted or attached. It is to be understood that semiconductor devices are often used in orientation different than their orientation during fabrication. Thus, when referring to a semiconductor device (e.g., a transistor), a semiconductor die containing a semiconductor device, and/or an integrated circuit (IC) package containing a semiconductor die during use, the definition of "above" in the preceding paragraph (i.e., the term "above" describes the relationship of two parts relative to Earth) will likely govern based on the usage context.

As used in this patent, stating that any part (e.g., a layer, film, area, region, or plate) is in any way on (e.g., positioned on, located on, disposed on, or formed on, etc.) another part, indicates that the referenced part is either in contact with the other part, or that the referenced part is above the other part with one or more intermediate part(s) located there between.

As used herein, connection references (e.g., attached, coupled, connected, and joined) may include intermediate members between the elements referenced by the connection reference and/or relative movement between those elements unless otherwise indicated. As such, connection references do not necessarily infer that two elements are directly connected and/or in fixed relation to each other. As used herein, stating that any part is in "contact" with another part is defined to mean that there is no intermediate part between the two parts.

Unless specifically stated otherwise, descriptors such as "first," "second," "third," etc., are used herein without imputing or otherwise indicating any meaning of priority, physical order, arrangement in a list, and/or ordering in any way, but are merely used as labels and/or arbitrary names to distinguish elements for ease of understanding the disclosed examples. In some examples, the descriptor "first" may be used to refer to an element in the detailed description, while the same element may be referred to in a claim with a different descriptor such as "second" or "third." In such instances, it should be understood that such descriptors are used merely for identifying those elements distinctly that might, for example, otherwise share a same name.

As used herein, "approximately" and "about" modify their subjects/values to recognize the potential presence of variations that occur in real world applications. For example, "approximately" and "about" may modify dimensions that may not be exact due to manufacturing tolerances and/or other real world imperfections as will be understood by persons of ordinary skill in the art. For example, "approximately" and "about" may indicate such dimensions may be within a tolerance range of +/- 10% unless otherwise specified in the below description.

As used herein, the phrase "in communication," including variations thereof, encompasses direct communication and/or indirect communication through one or more intermediary components, and does not require direct physical (e.g., wired) communication and/or constant communication, but rather additionally includes selective communication at periodic intervals, scheduled intervals, aperiodic intervals, and/or one-time events.

As used herein, "processor circuitry" is defined to include (i) one or more special purpose electrical circuits structured to perform specific operation(s) and including one or more semiconductor-based logic devices (e.g., electrical hardware implemented by one or more transistors), and/or (ii) one or more general purpose semiconductor-based electrical circuits programmable with instructions to perform specific operations and including one or more semiconductor-based logic devices (e.g., electrical hardware implemented by one or more transistors). Examples of processor circuitry include programmable microprocessors, Field Programmable Gate Arrays (FPGAs) that may instantiate instructions, Central Processor Units (CPUs), Graphics Processor Units (GPUs), Digital Signal Processors (DSPs), XPUs, or microcontrollers and integrated circuits such as Application Specific Integrated Circuits (ASICs). For example, an XPU may be implemented by a heterogeneous computing system including multiple types of processor circuitry (e.g., one or more FPGAs, one or more CPUs, one or more GPUs, one or more DSPs, one or more ASICs, etc., and/or a combination thereof) and application programming interface(s) (API(s)) that may assign computing task(s) to whichever one(s) of the multiple types of processor circuitry is/are best suited to execute the computing task(s).

### DETAILED DESCRIPTION

In recent years, the demand for high capacitance density on substrate packages has increased to support the power delivery needs of current generation integrated circuit (IC) packages. Some prior capacitor form factors, including metal-insulator-metal (MIM) capacitors on die, do not provide sufficient capacitance density for some applications, particularly, for higher input voltage power delivery architectures. Other prior capacitor form factors, including multi-layer ceramic capacitors (MLCC), have prohibitive vertical sizes and high inductances that limit processor operating frequency. As such, current capacitor form factors have difficulty scaling to meet growing capacitance density needs.

Examples disclosed herein include package substrate capacitors provided by carbon nanofiber (CNF) capacitors (e.g., an array of CNF capacitors). Specifically, examples disclosed herein employ carbon fibers (e.g., carbon nanofibers) to from conductive, high aspect ratio electrode contacts having comparatively high surface area. Example capacitors (e.g., carbon nanofiber capacitors) disclosed herein can provide relatively high capacitance densities from relatively high aspect ratio structures. For example, capacitance densities of up to 650 nanofarad per square millimeter (nF/mm²) with low equivalent series resistance (ESR) can be formed on a substrate (e.g., on glass or silicon wafers) using carbon nanofibers with aspect ratios of approximately 60:1 (e.g. plus or minus (+/-) 10%). Low equivalent series resistance means that the carbon nanofiber capacitors disclosed herein have less power loss, internal heating and/or ripple current than high ESR capacitors. A size (e.g., a diameter, a length, a thickness, an aspect ratio, etc.) of carbon nanofibers disclosed herein and/or spacing between carbon nanofibers of an array can be adjusted to tune or vary capacitance densities and/or structural properties or strength. For instance, forming carbon nanofibers with a lower aspect ratio (e.g., smaller heights and/or larger diameters or thicknesses) can increase a mechanical strength and/or robustness of the carbon nanofibers to provide more robust carbon nanofibers but can have reduce capacitance rating or density and/or can decrease equivalent series resistance (ESR). On the contrary, carbon nanofibers can be formed with higher aspect ratios (e.g., greater lengths, smaller diameters or thickness, etc.) can increase capacitance ratings or capacitance capability of the carbon nanofibers but can reduce an overall mechanical strength and/or robustness of the carbon nanofibers and increases equivalent series resistance (ESR). Increasing spacing (e.g., a pitch) between respective ones of carbon nanofibers can lower capacitance density or capability of the carbon nanofibers but can facilitate filling the space between the carbon nanofibers with material to increase a mechanical strength and/or reliability of the carbon nanofibers. Reducing spacing (e.g., a pitch) between respective ones of the carbon nanofibers can increase capacitance density or capability of the carbon nanofibers but can present more difficulties filing the space between the carbon nanofibers with material, which can result in carbon nanofibers having weaker or reduced mechanical strength or reliability. In some examples, carbon nanofiber capacitors disclosed herein are provided to alleviate or increase (e.g., free up) signal routing patterning in adjacent layers (e.g., build-up layers and/or die signal or power lines). In some examples, carbon nanofiber capacitors disclosed herein supplement capacitance values of thin film capacitors and/or other capacitors.

Example capacitors disclosed herein can be formed as part of a substrate fabrication process (e.g., in situ), thereby facilitating manufacturing substrate manufacturing. In some examples, carbon nanofiber capacitors disclosed herein can be formed with a process temperature of 390 degrees Celsius, which can enable implementation of capacitors on a glass core in panel processing. In some examples, carbon nanofiber capacitors can be formed with a process temperature less than 390 degrees Celsius (e.g., 200 degrees Celsius or lower) suitable for integration into build-up films or silicon cores or wafers. In some examples, example carbon nanofiber capacitors disclosed herein can be provided by depositing a catalyst via physical vapor deposition (PVD), producing the carbon nanofibers via plasma-enhanced chemical vapor deposition (PECVD), layering dielectric and a top conductive metal (e.g., titanium nitride (TiN)) via atomic layer deposition (ALD), adding a seed layer (e.g., copper seed), and plating a top metal contact via PVD.

Example semiconductor packages disclosed herein can be used with semiconductor dies or chiplets (e.g., tiles) that can implement controllers, microprocessors, Digital Signal Processors (DSPs), Central Processor Units (CPUs), Graphics Processor Units (GPUs), programmed microprocessors, Field Programmable Gate Arrays (FPGAs), Application Specific Integrated Circuits (ASICs), Reduced Instruction Set Computers (RISCs), any other circuitry and/or combinations thereof. Additionally, example semiconductor packages disclosed herein can be used with chiplets of a disaggregated die. Each chiplet (also referred to as a tile) may implement a dedicated function. Together, the chiplets may implement a complex circuitry. The complex circuitry can be any type of device that can be implemented as a plurality of chiplets that are physically separated from, but communicatively coupled to, one another. For example, processor circuitry may be implemented by two or more separate chiplets that together implement a microprocessor, etc. Alternatively, in other examples, example semiconductor packages disclosed herein may be different chips (e.g., a processor circuitry, a memory, and/or or some other type of component) that together implement a system on a chip (SoC) in a semiconductor package.

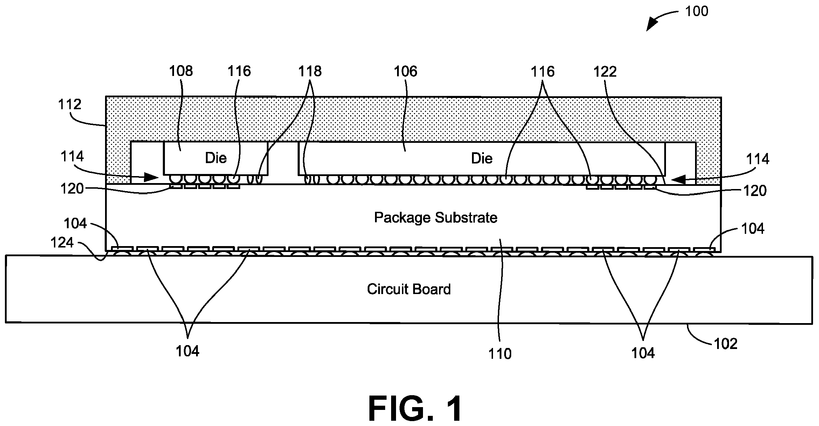

FIG. 1 illustrates an example IC package 100 (e.g., a semiconductor package) constructed in accordance with teachings disclosed herein. In the illustrated example, the IC package 100 is electrically coupled to a circuit board 102 via an array of contact pads or landing pads 104 (e.g., lands) on a mounting surface (e.g., a bottom surface) of the package. In some examples, the IC package 100 may include balls, pins, and/or pads, in addition to or instead of the landing pads 104 (e.g., contact pads), to enable the electrical coupling of the IC package 100 to the circuit board 102. In this example, the IC package 100 includes two semiconductor dies 106, 108 (e.g., silicon dies, chips or chiplets, etc.) that are mounted to a package substrate 110 and enclosed by a package lid or mold compound 112. While the example IC package 100 of FIG. 1 includes two dies 106, 108, in other examples, the IC package 100 may have only one die or more than two dies. In some examples, one of the dies 106, 108 (or a separate die) is embedded in the package substrate 110. The dies 106, 108 can provide any suitable type of functionality (e.g., data processing, memory storage, etc.).

In the illustrated example, each of the dies 106, 108 is electrically and mechanically coupled to the package substrate 110 via corresponding arrays of interconnects 114. In FIG. 1, the interconnects 114 are shown as bumps. However, the interconnects 114 may be any other type of electrical connection in addition to or instead of the bumps shown (e.g., balls, pins, pads, wire bonding, etc.). The electrical connections between the dies 106, 108 and the package substrate 110 (e.g., the interconnects 114) are sometimes referred to as first level interconnects. By contrast, the electrical connections between the IC package 100 and the circuit board 102 (e.g., the landing pads 104) are sometimes referred to as second level interconnects. In some examples, one or both of the dies 106, 108 may be stacked on top of one or more other dies and/or an interposer. In such examples, the dies 106, 108 are coupled to the underlying die and/or interposer through a first set of first level interconnects and the underlying die and/or interposer may be connected to the package substrate 110 via a separate set of first level interconnects associated with the underlying die and/or interposer. Thus, as used herein, first level interconnects refer to interconnects (e.g., balls, bumps, pins, pads, wire bonding, etc.) between a die and a package substrate or a die and an underlying die and/or interposer.

As shown in FIG. 1, the interconnects 114 of the first level interconnects include two different types of bumps, namely, core bumps 116 and bridge bumps 118. As used herein, core bumps are bumps on dies through which electrical signals pass between the dies and other components either within an IC package containing the dies (e.g., a different die) or external to the IC package. Thus, as shown in the illustrated example, when the dies 106, 108 are mounted to the package substrate 110, the core bumps 116 are physically connected and electrically coupled to contact pads 120 on an inner surface 122 of the package substrate 110. The contact pads 120 on the inner surface 122 of the package substrate 110 are electrically coupled to the landing pads 104 on the bottom (external) surface 124 of the package substrate 110 (e.g., a surface opposite the inner surface 122) via internal interconnects within the package substrate 110. As a result, there is a complete signal path between the core bumps 116 of the dies 106, 108 and the landing pads 104 mounted to the circuit board 102 that pass through the contact pads 120 and the interconnects 126 provided therebetween. As used herein, bridge bumps are bumps on the dies through which electrical signals pass between different ones of the dies within an IC package. More particularly, bridge bumps differ from core bumps in that bridge bumps electrically connect two or more different dies via an interconnect bridge embedded in an underlying substrate (e.g., the package substrate 110). As represented in FIG. 1, core bumps 116 are typically larger than bridge bumps 118. In some examples, the interconnect bridge and the associated bridge bumps 118 are omitted.

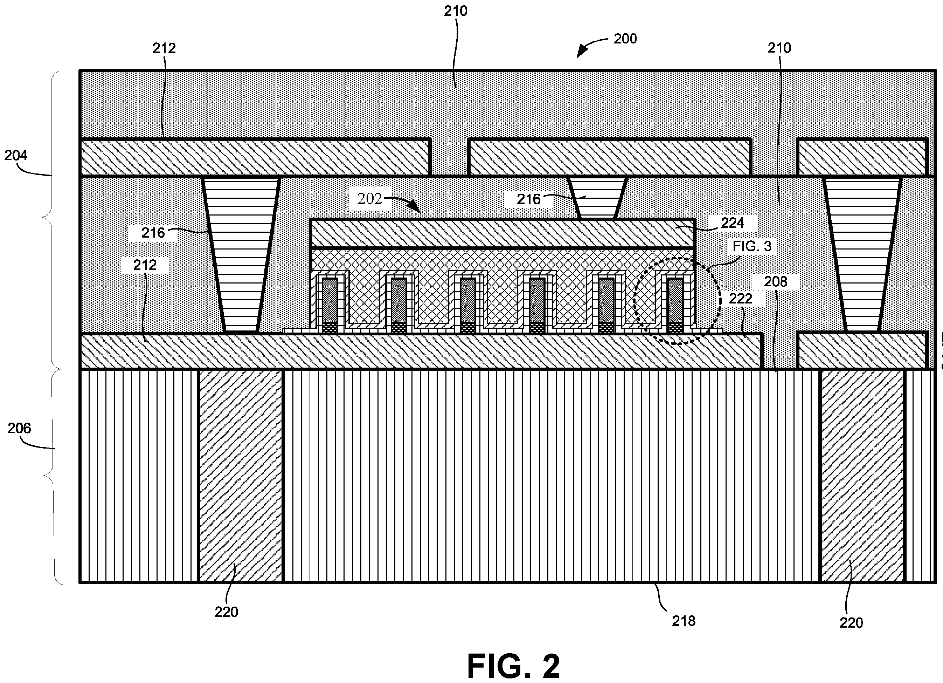

FIG. 2 is a cross-sectional view of an example package substrate 200 including an example capacitor apparatus 202 (e.g., a capacitor structure or carbon fiber capacitor (CFC) or carbon nanofiber (CNF) capacitor) in accordance with teachings of this disclosure. The package substrate 200 of the illustrated example can implement the example package substrate 110 of FIG. 1. In some examples, the capacitor apparatus 202 of the illustrated example can be provided or fabricated within the circuit board 102, the dies 106, 108, an interposer and/or any other structure of a semiconductor package and/or electronic device. In some examples, the package substrate 200 can be an interposer and/or any other substrate(s). In some examples, the package substrate 200 can be an integrated circuit package.

The capacitor apparatus 202 of the illustrated example is integrated into the package substrate 200. Specifically, the capacitor apparatus 202 of the illustrated example is fabricated with the package substrate 200 in-situ. The package substrate 200 of the illustrated example includes a build-up layer 204 (e.g., a first substrate layer) and a core layer 206 (e.g., a second substrate layer). In the illustrated example, the build-up layer 204 is provided on (e.g., a first surface 208) of the core layer 206. The capacitor apparatus 202 of the package substrate 200 of the illustrated example is provided or formed with the build-up layer 204 and the core layer 206.

The build-up layer 204 of the illustrated example includes insulation or dielectric layers 210 and conductive layers 212 (e.g., patterned lithographically). The conductive layers 212 form a plurality of electrical contacts or traces within the dielectric layers 210. The traces provided by the conductive layers 212 of the illustrated example define signal traces (e.g., signaling lines) to transfer signals or information between various components (e.g., transistors, capacitors, resistors, backend layers, etc. and/or other circuitry) of the package substrate 200 and/or power traces for transferring or carrying power to the various components of the package substrate 200, including, for example, the capacitor apparatus 202. Electrically conductive vias or through substrate vias (TSV) 216 (e.g., copper plated vias) extend through the dielectric layers 210 and electrically interconnect the conductive layers 212. A second surface 218 (e.g., a second side) of the core layer 206 opposite the first surface 208 (e.g., a first side) can include a plurality of solder connectors (e.g., solder balls, solder pads, interconnects 114 of FIG. 1) to electrically couple the package substrate 200 and a printed circuit board (e.g., the circuit board 102 of FIG. 1), an interposer and/or any other substrate(s). The dielectric layers 210 can include, but is not limited to, titanium dioxide (TiO₂), hafnium dioxide (HfO₂), hafnium zirconium oxide (HZO) (e.g., HZO film), and/or any other suitable dielectric material(s) (e.g., non-conducting material(s) that stores electrical charges). The conductive layers 212 can be copper, gold, aluminum and/or any other electrically conductive material(s).

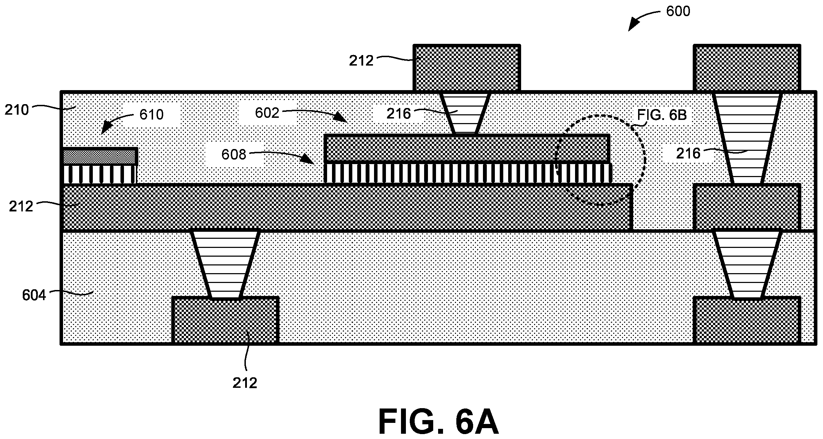

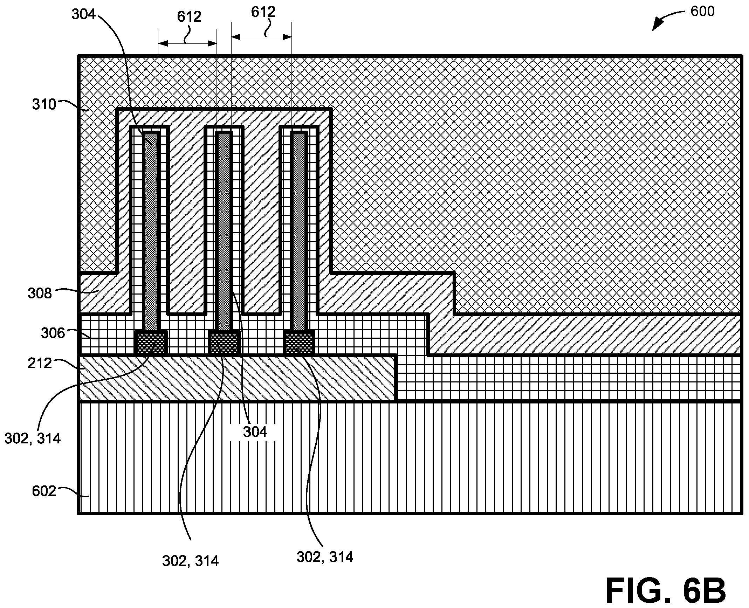

The core layer 206 of the illustrated example is a substrate composed of glass (e.g., a glass substrate or glass core). To communicatively and/or electrically couple the traces 214 and/or conductive layers 212, the core layer 206 of the illustrated example employs a plurality of through glass vias (TGVs) 220 (e.g., copper plated vias). In some examples, the core layer 206 can include, but not limited to, at least one of: aluminosilicate, borosilicate, alumino-borosilicate, silica, and/or fused silica. In some examples, the core layer 206 can include one or more additives including, but not limited to: aluminum oxide (Al2O3), boron trioxide (B2O3), magnesia oxide (MgO), calcium oxide (CaO), stoichiometric silicon oxide (SrO), barium oxide (BaO), stannic oxide (SnO2), nickel alloy (Na2O), potassium oxide (K2O), phosphorus trioxide (P2O3), zirconium dioxide (ZrO2), lithium oxide (Li2O), titanium (Ti), and/or zinc (Zn). In some examples, the core layer 206 can include silicon and oxygen. In some examples, the core layer 206 can include silicon, oxygen and/or one or more of aluminum, boron, magnesium, calcium, barium, tin, sodium, potassium, strontium, phosphorus, zirconium, lithium, titanium, and/or zinc. In some examples, the core layer 206 includes at least 23 percent silicon by weight and at least 26 percent oxygen by weight. In some examples, the glass core is a layer of glass including silicon, oxygen and aluminum. In some examples, the core layer 206 includes at least 23 percent silicon by weight, at least 26 percent oxygen by weight, and at least 5 percent aluminum by weight. In some examples, the core layer 206 can be an amorphous solid glass layer. In some examples, the core layer 206 is a layer of glass that does not include an organic adhesive or an organic material. In some examples, the core layer 206 is a solid layer of glass having a rectangular shape in plan view. In other examples, the core layer 206 can be silicon (e.g., see FIG. 6), a dielectric material and/or any other material(s).

The capacitor apparatus 202 of the illustrated example is electrically coupled to a first conductive contact 222 (e.g., a first electrode) and a second conductive contact 224 (e.g., a second electrode) provided by the conductive layers 212. In some examples, the capacitor apparatus 202 can be communicatively and/or electrically coupled (e.g., in parallel) to a thin film capacitor (TFC) formed in-plane with the build-up layer 204. In some examples, the capacitor apparatus 202 can supplement a TFC such that an overall capacitance capability is provided by the capacitor apparatus 202 and the TFC (e.g., a summation of a maximum capacitance rating or measurement of the capacitor apparatus 202 and a maximum capacitance rating or measurement of the TFC). Although the package substrate 200 of the illustrated example includes a single array or set of carbon nanofiber capacitors, some example package substrates can include more than one array of carbon nanofiber capacitors, and/or any number of carbon nanofiber capacitors. The capacitor apparatus 202 of the illustrated example provides non-planar capacitors in a package substrate.

The capacitor apparatus 202 provides capacitance to support power delivery to dies coupled to the package substrate 200 (e.g., the dies 106, 108 of FIG. 1, etc.). In the illustrated example of FIG. 2, the capacitor apparatus 202 increase the capacitance density of the capacitor structure when compared to prior capacitors that include layers that are disposed entirely within a single plane (e.g., a planar top electrode, a planar bottom electrode, a planar dielectric layer, etc.).

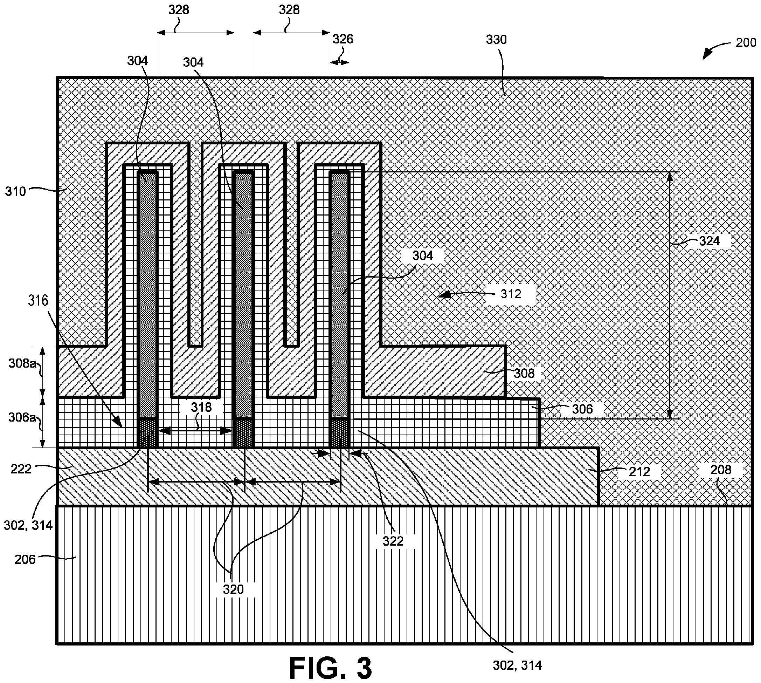

FIG. 3 is an enlarged portion of the capacitor apparatus 202 of FIG. 2. The capacitor apparatus 202 of the illustrated example includes a catalyst layer 302, a plurality of carbon fibers or carbon nanofibers 304 (e.g., carbon tubes or nanotubes), a thin dielectric film or layer 306, a thin electrode film or layer 308, and a fill layer 310 (e.g., a top or upper electrode, an upper electrode layer or contact, etc.). The carbon nanofibers 304 of the capacitor apparatus 202 of the illustrated example includes an example carbon fiber or carbon nanofiber array 312 of the carbon nanofibers 304.

The catalyst layer 302 of the illustrated example is positioned on or supported by the conductive layer 212 defining the first conductive contact 222 (e.g., a first conductive layer). The catalyst layer 302 of the illustrated example is a metal catalyst layer. The catalyst layer 302 promotes growth of the carbon nanofibers 304. In particular, the catalyst layer 302 includes a plurality of catalysts 314 providing a catalyst array 316 provided or defined by the catalysts 314 (e.g., disks, spots, bases, etc.). The catalyst array 316 defines a pattern and/or footprint of the carbon nanofiber array 312 of the carbon nanofibers 304. Each carbon nanofiber 304 includes a catalyst 314 that promotes carbon fiber growth during fabrication. Thus, respective ones of the catalysts 314 provide a base or catalyst for respective ones of the carbon nanofibers 304. In other words, respective ones of the carbon nanofibers 304 includes respective ones of the catalysts 314. As shown in this example, respective ones of the carbon nanofibers 304 are positioned on respective ones of the catalysts 314. The carbon nanofibers 304 extend or protrude from the catalyst layer 302 and/or respective ones of the catalysts 314 and toward the second conductive contact 224 (FIG. 2). For example, the carbon nanofibers 304 extend from the respective ones of the catalysts 314 by a distance or length 324. The carbon nanofibers 304 of the illustrated example extend substantially perpendicular to (e.g., vertically relative to) the catalyst layer 302 and/or the first conductive contact 222 between the first conductive contact 222 and the second conductive contact 224. As used herein, "substantially vertically" or "substantially perpendicular" means perfectly vertical or perpendicular or within 5 degrees of perfectly vertical or perfectly perpendicular. In some examples, the carbon nanofibers 304 can be grown via catalytic plasma-enhanced chemical vapor deposition (C-PECVD) at temperatures between 200 degrees Celsius and 400 degrees Celsius.

The catalysts 314 are spaced apart on the first conductive contact 222 by a space or distance 318. The distance 318 between respective ones of the catalysts 314 of the catalyst layer 302 defines a pitch 320 of the carbon nanofibers 304. Additionally, the catalysts 314 include a width or diameter 322. The catalysts 314 of the illustrated example have a circular shape. The width 322 of the catalysts 314 of the illustrated example is between approximately 100 nanometers and 1000 nanometers. In some examples, the width 322 of the catalysts 314 can be the same as a width or diameter 326 of the carbon nanofibers 304 or can be different than the width or diameter 326 of the carbon nanofibers 304. In some examples, the catalysts 314 can be have a rectangular shape and/or any other shape. The catalysts 314 of the illustrated example can be, but not limited to, nickel (Ni), cobalt (Co), copper-nickel (Cu-Ni) alloy, platinum (Pt), palladium (Pd), ruthenium (Ru) and/or any other metal or alloy material(s).

The length 324, the width or diameter 326 and/or the pitch 320 (e.g., a spacing between center points) between carbon nanofibers 304 can be tuned or adjusted to vary a capacitive density of the carbon nanofiber array 312 of the carbon nanofibers 304. For example, the carbon nanofibers 304 can be fabricated with thicker, shorter fibers and with greater spacing for more robust arrays or with longer, thinner fibers and with less spacing for more capacitance capacity, as needed. The width 326 of the carbon nanofibers 304 can range between 100 to 1000 nanometers. The length 324 of the carbon nanofibers 304 can range between approximately 1 micron and 25 microns. Thus, example carbon nanofibers 304 disclosed herein can have an aspect ratio (length-to-width ratio) of between 1 to 100. In some examples, the aspect ratio can be between approximately 10 and 50.

A carbon nanofiber having a higher aspect ratio provides greater capacitance density than a carbon nanofiber formed with a lower aspect ratio. However, a carbon nanofiber having a lower aspect ratio provides greater mechanical strength or characteristics than a carbon nanofiber having a higher aspect ratio. Thus, the aspect ratio has a direct relationship with capacitance density and an inverse relationship with mechanical strength. The pitch 320 defined between respective ones of carbon nanofibers 304 defines gaps 328 between the carbon nanofibers 304. The pitch 320 of the example carbon nanofibers 304 in the carbon nanofiber array 312 can range between 1.5 times to 4 times the width 326 (e.g., diameter) of the carbon nanofibers 304. In some examples, the pitch 320 can be approximately 2 times the width 326 of the carbon nanofiber 304.

The thin dielectric film 306 of the illustrated example conforms to the carbon nanofibers 304. For example, the thin dielectric film 306 is conformally deposited on the carbon nanofibers 304 and/or the package substrate 200. The thin dielectric film 306 is positioned on the carbon nanofibers 304 such that the catalyst layer 302 and the carbon nanofibers 304 are positioned between the first conductive contact 222 and the thin dielectric film 306. Specifically, the thin dielectric film 306 is a thin layer that conforms to (e.g., a shape or profile of) the carbon nanofibers 304. Thus, the thin dielectric film 306 of the illustrated example is at least partially positioned between or within the gaps 328 and follows a shape, pattern and/or profile of the carbon nanofibers 304 and/or the carbon nanofiber array 312. In other words, the thin dielectric film 306 encases or completely surrounds the carbon nanofibers 304 and the catalysts 314. In some examples, the thin dielectric film 306 can have a thickness 306a of between approximately 5 nanometers and 40 nanometers. In the illustrated example, the thickness 306a has a uniform thickness when applied to the carbon nanofibers 304 and/or the package substrate 200. However, in some examples, the thickness 306a of the thin dielectric film 306 can vary or have a non-uniform thickness.

The thin electrode film 308 is positioned or provided on the thin dielectric film 306. The thin electrode film 308 can be conformally deposited around the carbon nanofibers 304 and/or the thin dielectric film 306. In some examples, the thin electrode film 308 can be deposited on the thin dielectric film 306 via any other manufacturing processes. The thin electrode film 308 of the illustrated example conforms to the shape, pattern and/or profile of the carbon nanofibers 304, the carbon nanofiber array 312 and/or thin dielectric film 306. Thus, the thin electrode film 308 at least partially fills or is at least partially positioned between the gaps 328 of respective ones of the carbon nanofibers 304. In other words, the thin electrode film 308 encases or completely surrounds the carbon nanofibers 304, the catalysts 314 and/or the thin dielectric film 306. In some examples, the thin electrode film 308 has a thickness 308a of between approximately 5 nanometers and 40 nanometers. In the illustrated example, the thickness 308a has a uniform thickness when applied to the carbon nanofibers 304 and/or the package substrate 200. However, in some examples, the thickness 308a of the thin electrode film 332 can vary or have a non-uniform thickness. In some examples, the thickness 306a of the thin dielectric film 306 and the thickness 308a of the thin electrode film 308 collectively have a thickness of approximately between 5 nanometers and 40 nanometers. In some examples, the thin dielectric film 306 is hafnium dioxide (HfO2) and the thin electrode film 332 is titanium nitride (TiN), where the HfO2 and the TiN are deposited on the carbon nanofibers 304 via atomic layer deposition (ALD).

The fill layer 310 of the illustrated example is positioned on the thin electrode film 308. Specifically, the fill layer 310 is metal (e.g., a metal fill layer) and defines an upper electrode 330 (e.g., a top electrode) of the capacitor apparatus 202. In the illustrated example, the fill layer 310 electrically couples the carbon nanofiber array 312 and the second conductive contact 224 (FIG. 2). The fill layer 310 of the illustrated example at least partially fills or is at least partially positioned between the gaps 328 between the carbon nanofibers 304. Thus, in the illustrated example, at least portions of the thin dielectric film 306, the thin electrode film 308 and/or the fill layer 310 are positioned within and/or between the gaps 328 formed between the carbon nanofibers 304. The carbon nanofibers 304 provided by the catalyst layer 302 of the illustrated example can be fabricated in-situ with the fabrication of the package substrate 200. Very high capacitance densities can be achieved from very high aspect ratio carbon nanofiber structures. For example, capacitance densities of 650 nanofarad per square millimeter (nF/mm²) can be achieved from carbon nanofibers having an aspect ratio (e.g., length-to-diameter aspect ratio) of approximately 60:1.

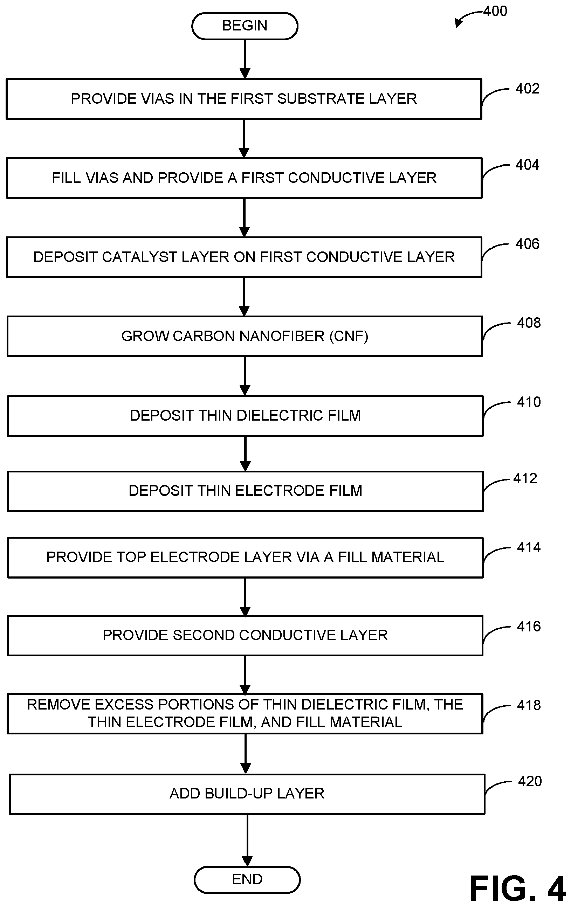

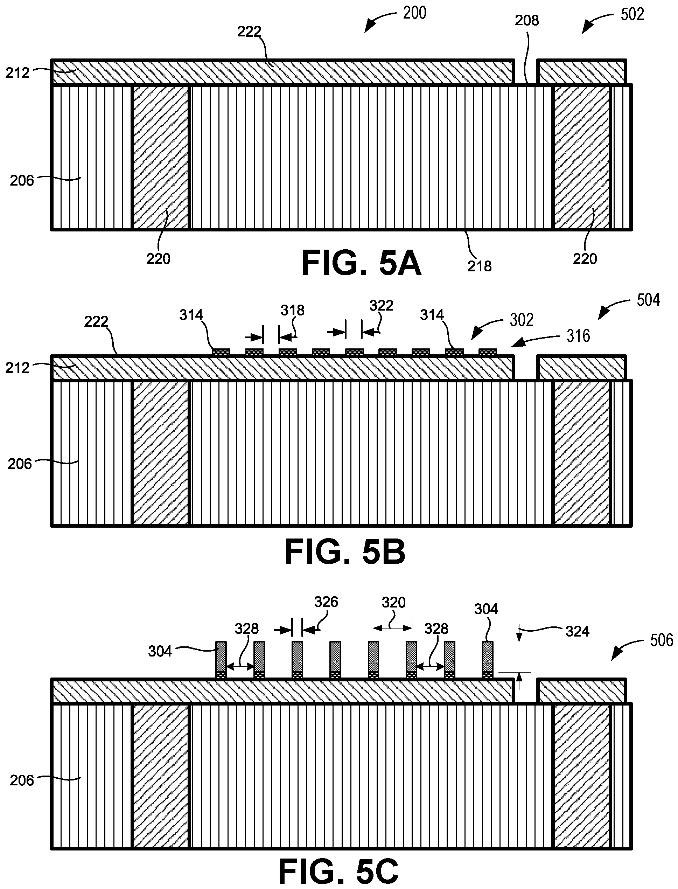

FIG. 4 is a flowchart of an example method 400 of fabricating an example semiconductor package (e.g., the IC package 100 of FIG. 1), a package substrate (e.g., the package substrate 200 of FIGS. 2 and 3), an interposer, and/or any other structure having capacitor apparatus 202 disclosed herein. To facilitate discussion of the example method 400, the example method 400 is described in connection with the example package substrate 200 of FIGS. 2 and 3. For example, FIGS. 5A-5H are cross-sectional schematic illustrations of the example package substrate 200 of FIGS. 2 and 3 at various manufacturing stages 502, 504, 506, 508, 510, 512, 514, 516 corresponding to the example method 400 of FIG. 4. While an example manner of fabricating the example package substrate 200 has been illustrated in FIGS. 4 and 5A-5H, one or more of the steps and/or processes illustrated in FIGS. 4 and 5A-5H may be combined, divided, re-arranged, omitted, eliminated and/or implemented in any other way. Further still, the example methods of FIGS. 4 and 5A-5H may include processes and/or steps in addition to, or instead of, those illustrated in FIGS. 4 and 5A-5H and/or may include more than one of any or all of the illustrated processes and/or steps.

Further, although the example methods are described with reference to the flowchart illustrated in FIG. 4 and the associated manufacturing stages represented in FIGS. 5A-5H, many other methods or processes of fabricating electronic packages may alternatively be used. For example, the package substrate 200 disclosed herein can be provided using conventional manufacturing techniques. For example, some example processes that can be used include laser drilling, laser etching, polishing, photolithography, integrated circuit microfabrication techniques, wet etching, dry etching, anisotropic etching, spin coating, electroforming or electroplating, laser ablation, sputtering, chemical deposition, plasma deposition, surface modification, injection molding, hot embossing, thermoplastic fusion bonding, low temperature bonding using adhesives, stamping, machining, 3-D printing, laminating, and/or any other processes commonly used for manufacture of semiconductor devices.

Referring to the example method 400 of FIG. 4, the method 400 begins by providing vias in a substrate layer (block 402). For example, referring to FIG. 5A, the core layer 206 can be composed of quartz or any other glass material(s) and the TGVs 220 can be provided in the core layer 206 between the first surface 208 of the core layer 206 and the second surface 218 of the core layer 206. Fabrication of the TGVs 220 can be achieved by any appropriate process including, but not limited to, drilling (e.g., mechanical and/or laser drilling and subsequent cleaning), etching, chemical and/or mechanical polishing, and/or any other through glass vias (TGVs) manufacturing techniques and/or any other semiconductor manufacturing process(es).

After fabrication of the vias of block 402, the vias are filled with conductive material and a first conductive layer is deposited on the substrate layer (block 404). For example, referring to FIG. 5A, the TGVs 220 are filled with conductive material and the conductive layer 212 is positioned on the first surface 208 of the core layer 206 to provide the first conductive contact 222. The conductive material and/or the conductive layer 212 can be fabricated from electrically conductive material(s) including, but not limited to, copper, aluminum, gold, and/or any other electrically conductive material that can carry or enable passage of electrical current. The filling of the TGVs 220 and/or the conductive layer 212 can be provided on the core layer 206 via, for example, a semi-additive process, a build-up film process, etching, lithography and/or any other suitable manufacturing process(es).

Next, a catalyst layer is deposited on the first conductive layer (block 406). For example, referring to FIG. 5B, the catalyst layer 302 is positioned on the first conductive contact 222. The catalyst layer 302 of the illustrated example includes the plurality of catalysts 314 each having the width 322 and spaced apart from each other by the distance 318. The catalyst layer 302 and/or catalysts 314 promotes growth of the carbon nanofibers 304 during fabrication. The catalyst layer 302 is fabricated by depositing the catalysts 314 in the catalyst array 316 that is complementary and/or identical to a footprint or pattern of the carbon nanofiber array 312 of carbon nanofibers 304. Thus, the pitch 320 (FIG. 3) of the carbon nanofiber array 312 is controlled or provided by the distance 318 of the catalysts 314 (e.g., the catalyst disks) on the first conductive contact 222. The catalyst array 316 can be fabricated in a symmetrical grid pattern (e.g., rows and columns) or an asymmetrical grid pattern. The catalyst layer 302 and/or the catalysts 314 of the illustrated example can be a metal and/or an alloy material including, but not limited to, nickel (Ni), cobalt (Co), copper-nickel (Cu-Ni) alloy, platinum (Pt), palladium (Pd), ruthenium (Ru) and/or any other suitable metal and/or alloy. The catalyst layer 302 of the illustrated example is a lithographically patterned metal catalyst layer. The catalyst layer 302 can be patterned on the first conductive contact 222 via lithography and/or deposited and patterned on the first conductive contact 222 via deposition (e.g., evaporated and/or sputtered (lift-off lithography or etched)).

With the catalyst layer fabricated, a carbon nanofiber array is grown (block 408). Referring to FIG. 5C, to promote growth of the carbon nanofibers 304, the example carbon nanofibers 304 disclosed herein can be grown via catalytic plasma-enhanced chemical vapor deposition (C-PECVD). Specifically, the carbon nanofibers 304 can be grown at temperatures of approximately 390 degree Celsius via C-PECVD manufacturing process(es) when the core layer 206 is a glass core (e.g. a solid glass core). Employing higher temperatures enhances growth of the carbon nanofibers 304 to provide an increased aspect ratio (e.g., 60:1) and, thus, capacitance densities. The carbon nanofiber array 312 is determined by the placement of the catalysts 314. Thus, the pitch 320 of the carbon nanofiber array 312 is controlled or provided by the distance 318 of the catalysts 314 (e.g., the catalyst disks) on the first conductive contact 222 as shown above in FIG. 5B. The length 324 of the carbon nanofibers 304 is controlled by a temperature of the C-PECVD manufacturing process.

However, in some examples, the carbon nanofibers 304 can be formed with substrates composed of other materials. For example, carbon nanofibers 304 disclosed herein can be formed with core layers composed of silicon, dielectric layers (e.g., the build-up layer 204 of FIG. 2), and/or any other layer or substrate composed of other material(s). In some such examples, promotion of the carbon nanofiber growth can be performed at temperatures less than 390 degrees Celsius. For examples, carbon nanofiber growth can be performed at temperatures of 200 degrees Celsius when the core layer 206 is composed of organic dielectric layer, such as a build-up layer or an organic core. However, it is noted that growth promotion can increase when higher temperatures are employed. Thus, carbon nanofibers 304 that are grown at higher temperatures via C-PECVD can have greater aspect ratios, greater lengths (e.g., the length 324) and/or greater capacitance densities than carbon nanofibers 304 grown at lower temperatures. Therefore, capacitive density is directly proportional to the temperature employed for carbon nanofiber growth. For instance, carbon nanofibers 304 can be fabricated with greater aspect ratios, greater lengths (e.g., the length 324) and/or greater capacitance densities when grown at a temperature of 390 degree Celsius compared to carbon nanofibers 304 grown at a temperature of 200 degrees Celsius. For example, a carbon nanofiber array grown via C-PECVD at 390 degrees Celsius on a glass core (e.g., a solid glass core) can have aspect ratios of 60:1 and capacitive densities of 650 nanofarad per square millimeter (nF/mm²). In contrast, carbon nanofibers grown via C-PECVD manufacturing process(es) at temperatures of 200 degrees Celsius on a silicon core can have capacitive densities of 100 nanofarad per square millimeter (nF/mm²).

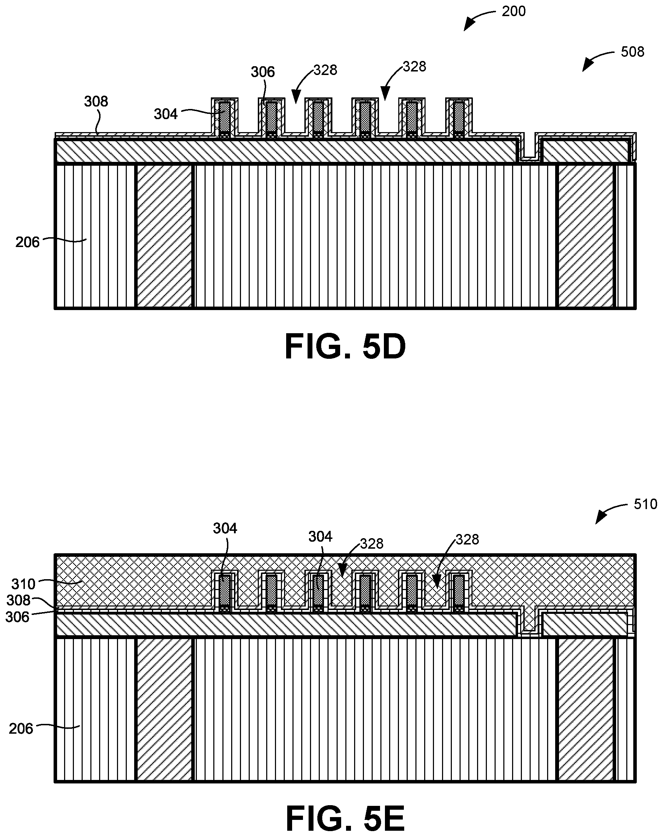

After fabrication of the carbon nanofibers, a thin electrode film is conformally deposited on the carbon nanofibers (block 410). For example, referring to FIG. 5D, the thin dielectric film 306 is a thin film deposited on the carbon nanofibers 304. The thin dielectric film 306 of the illustrated example is a thin layer that can be conformally deposited around the carbon nanofibers 304 (e.g., high-aspect ratio (e.g., 10:1, 25:1, 50:1, 60:1) carbon nanofibers) using atomic layer deposition (ALD), plasma-enhanced chemical vapor deposition (PECVD) and/or any other suitable process. Specifically, the thin dielectric film 306 conforms to a shape and/or profile of the carbon nanofibers 304. In the illustrated example, the thin dielectric film 306 is positioned between the spaces or gaps 328 formed between respective ones of the carbon nanofibers 304. Thus, the thin dielectric film 306 at least partially fills in the spaces or gaps 328 between respective ones of the carbon nanofibers 304. In other words, the thin dielectric film 306 is a thin film that encases or surrounds (e.g., completely surrounds) the carbon nanofibers 304 and the catalysts 314. Example dielectric materials of the thin dielectric film 306 can include, but not limited to, fluorite (e.g., hafnium (IV) oxide (HfO2), zirconium dioxide (ZrO2), titanium dioxide (TiO2), lanthanum oxide (La2O3), tantalum pentoxide (Ta2O3), and their compounds), perovskite structures (e.g., barium titanate (BaTiO3), strontium titanate (SrTiO3), bismuth ferrite (BiFeO3) and sometimes with dopants such as lanthanum (La), hafnium (Hf), and zirconium (Zr)), etc. The thin dielectric film 306 also may include multiple layers of combinations of dielectric materials, such as aluminum oxide (Al2O3) and hafnium dioxide (HfO2), for example.

After application of the thin dielectric film, a thin electrode film is applied to the thin electrode film (block 412). For example, referring to FIG. 5D, the thin electrode film 308 positioned or deposited on the thin dielectric film 306. In some examples, the thin electrode film 308 can be conformally deposited around the thin dielectric film 306 and/or the carbon nanofibers 304 (e.g., having high-aspect ratio (e.g., 20:1, 25:1, 50:1, 60:1)) using ALD and/or any other suitable process. The thin electrode film 308 can include materials including, but not limited to, metals (e.g., tantalum nitride (TaN), titanium nitride (TiN), ruthenium (Ru), iridium (Ir), platinum (Pt), tantalum (Ta), niobium nitride (NbN), niobium (Nb), tungsten metal (W), hafnium (Hf), zirconium (Zr), titanium (Ti)), conducting metal oxides (e.g., ruthenium oxide (RuO2), iridium (IV) oxide (IrO2), niobium oxide (Nb2O5)), a combination thereof, etc. The thin electrode film 332 can be deposited by atomic layer deposition (ALD), plasma-enhanced chemical vapor deposition (PECVD) and/or any other suitable process. In some examples, the thin dielectric film 306 and the thin electrode film 308 can be conformally deposited around high-aspect ratio CNFs using atomic layer deposition (ALD). In some examples, the thin electrode film 308 can collectively have a thickness of between approximately 5 nanometers and 40 nanometers. In some examples, the thin dielectric film 306 is hafnium dioxide (HfO2) and the thin electrode film 332 is titanium nitride (TiN), where the HfO2 and the TiN are deposited on the carbon nanofibers 304 via atomic layer deposition (ALD).

Next, an upper electrode layer is provided (block 414). For example, referring to FIG. 5E, the fill layer 310 is a conductive material provided on the thin electrode film 308 via plasma-enhanced chemical vapor deposition (PECVD) followed by planarization. The fill layer 310 of the illustrated example fills and/or is positioned between the gaps 328 of the carbon nanofibers 304 of the carbon nanofiber array 312. The fill layer 310 is a metal material positioned on the thin electrode film 308 that defines the upper electrode 330 and fills the gaps 328 between the carbon nanofibers 304. Thus, the gaps 328 between the carbon nanofibers 304 after coating them with the thin dielectric film 306 and the thin electrode film 308 can be filled or partially filled by the fill layer 310 (e.g., a top contact process). Employing the fill layer 310 to fill the gaps 328 at least partially yields a lower equivalent series resistance (ESR). In some cases, the fill layer 310 (e.g., a top contact) can be applied to the thin electrode film 308 via sputtering, which can be employed to fill gaps (e.g., the gaps 328) of low-aspect ratio carbon nanofibers. Such a procedure may cause voids in the high aspect ratio carbon nanofibers, which can be acceptable also when the thin electrode film 308 is thicker and ESR requirements are not critical. In some examples, the gaps 328 can be at least partially filled with dielectric materials for structural strengthening. For example, PECVD of SiO2 or an organic fill material can be used as a structural filler material. The fill layer 310 provides the top or upper electrode 330 of the capacitor apparatus 202.

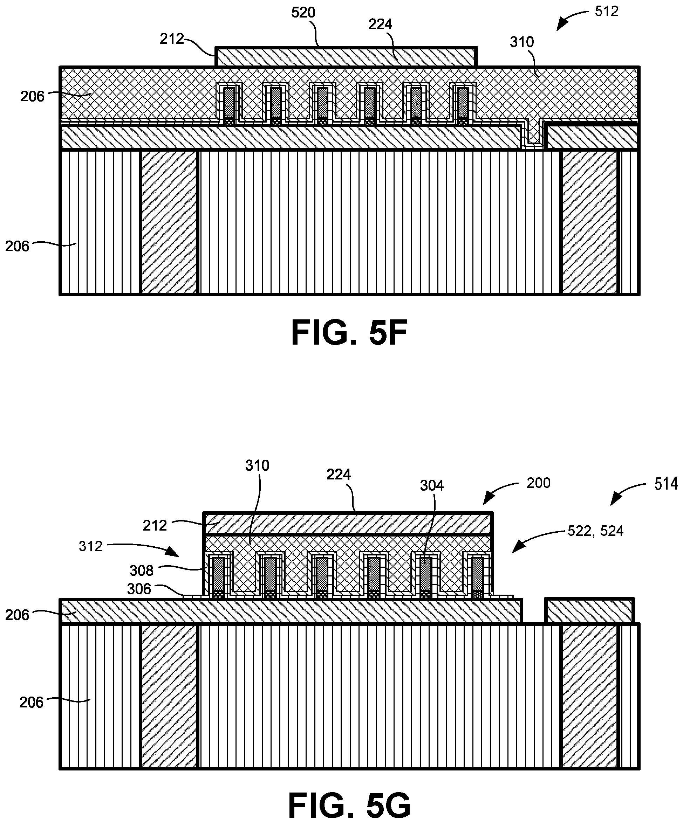

A second conductive layer is provided on the upper electrode layer (block 416). For example, referring to FIG. 5F, a conductive material 520 is positioned on the fill layer 310 to fabricate the conductive layer 212 providing the second conductive contact 224 (e.g., a second electrode layer). The conductive material 520 can be copper, aluminum, gold, and/or any other electrically conductive material(s) that can carry or enable passage of electrical current. The conductive material 520 can be provided on the fill layer 310 via, for example, a semi-additive process, a build-up film process, etching, and/or any other suitable manufacturing process(es). For example, the second conductive contact 224 can be a patterned electroplated copper layer formed via standard semi-additive processes for the upper or top contact and/or etch hardmask.

After fabrication of the second conductive layer at block 416, excess portions of a conformal layer and fill material are removed (block 418). For example, referring to FIG. 5G, excess portions of the thin dielectric film 306, the thin electrode film308 and the fill layer 310 are etched from an area 522 adjacent (e.g., outside) of a periphery or outermost edge of the carbon nanofiber array 312 to form the capacitor apparatus 202 between the first conductive contact 222 and the second conductive contact 224. In other words, the area etched is an area of the package substrate 200 that does not have or include the carbon nanofibers 304. Thus, the only remaining portions of the thin dielectric film 306, the thin electrode film 308 and the fill layer 310 are between the first conductive contact 222 and the second conductive contact 224 (e.g., in a vertical orientation in FIG. 5G) and adjacent or within an outer periphery 524 of the carbon nanofiber array 312 (e.g., in a horizontal orientation in FIG. 5G).

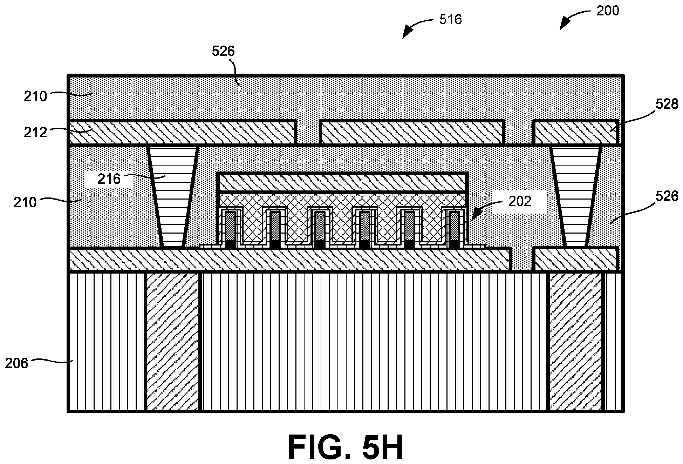

After fabrication of the capacitor apparatus 202, a build-up layer is provided on the core layer 206 (block 420). For example, referring to FIG. 5H, a dielectric material 526, the vias 216, and a conductive material 528 (e.g., the conductive layers 212) are provided around the capacitor apparatus 202 to provide the build-up layer 204 of FIG. 2. The build-up layer 204 can be provided on the core layer 206 using conventional semiconductor manufacturing techniques or processes including, but not limited to photolithography, integrated circuit microfabrication techniques, wet etching, dry etching, anisotropic etching, spin coating, electroforming or electroplating, laser ablation, sputtering, chemical deposition, plasma deposition, surface modification, injection molding, hot embossing, thermoplastic fusion bonding, low temperature bonding using adhesives, stamping, machining, 3-D printing, laminating, semi-additive deposition and/or any other processes commonly used for manufacture of semiconductor packages.

FIG. 6A is a cross-sectional view of another example package substrate 600 having another example capacitor structure or carbon nanofiber (CNF) capacitor apparatus 602 (e.g., carbon nanofiber (CNF) capacitor) disclosed herein. FIG. 6B is an enlarged portion of the example cross-sectional view of FIG. 6A. Many of the components of the example package substrate 600 of FIGS. 6A and 6B are substantially similar or identical to the components described above in connection with the package substrate 200 of FIGS. 2-5H. As such, those components will not be described in detail again below. Instead, the interested reader is referred to the above corresponding descriptions for a complete written description of the structure and operation of such components. To facilitate this process, similar or identical reference numbers will be used for like structures in FIGS. 6A and 6B as used in FIGS. 2-5H.

For example, the package substrate 600 of the illustrated example includes the capacitor apparatus 602, a core layer 604, a dielectric layer 210, and conductive layers 212. The package substrate 600 of the illustrated example can implement the example package substrate 110 of FIG. 1. In some examples, the capacitor apparatus 602 of the illustrated example can be provided or formed with the circuit board 102, the dies 106, 108, an interposer and/or any other structure of a semiconductor package and/or electronic device. In some examples, the package substrate 600 can be an interposer and/or any other substrate(s).

The package substrate 600 of the illustrated example is an example build-up layer (e.g., the build-up layer 204, build-up dielectric film). Thus, the core layer 604 is composed of a dielectric material. In some examples, the core layer 604 can be a silicon substrate or silicon wafer. The capacitor apparatus 602 of the illustrated example is provided on the core layer 604. The capacitor apparatus 602 of the illustrated example includes a first CNF array 608 and a second CNF array 610 spaced from the first CNF array 608. Although the package substrate 600 of the illustrated example includes the first CNF array 608 and the second CNF array 610, the package substrate 600 can include only a single CNF array, more than two CNF arrays, and/or any number of CNF arrays or carbon nanofibers. The first CNF array 608 is identical in construction relative to the second CNF array. Thus, only the first CNF array 608 is described herein.

Referring to FIG. 6B, the capacitor apparatus 602 of the illustrated example is substantially similar to the capacitor apparatus 202. For example, the capacitor apparatus 602 includes a catalyst layer 302 having a plurality of catalysts 314, carbon fibers or carbon nanofibers 304, a thin dielectric film 306, a thin electrode film 308, and a fill layer 310 (e.g., an upper or top electrode). In the illustrated example, the fill layer 310 is not positioned within gaps 612 between respective ones of the carbon nanofibers 304. In the illustrated example, the thin dielectric film 306 and the thin electrode film 308 is positioned within and/or between gaps 612 of respective ones of the carbon nanofibers 304. The fill layer 310 is not positioned in the gaps 612. Thus, the gaps 612 of the illustrated example are mostly filled (e.g., between about 85 and 99 percent filled) with the thin electrode film 308. In the illustrated example, the fill layer 310 is positioned on the thin electrode film 308. The fill layer 310 provides a contact or electrode to the thin electrode film 308 that can be deposited on the first CNF array 608 by any manufacturing method.

The method 400 of FIG. 4 can be employed to fabricate the example capacitor apparatus 602 of FIGS. 6A and 6B. However, unlike the glass core provided by the core layer 206 of the package substrate 200 of FIGS. 2 and 3, the capacitor apparatus 602 is fabricated on the core layer 604 at a lower temperature compared to the capacitor apparatus 202 of FIGS. 2 and 3. For example, the CNF capacitor apparatus 602 of the illustrated example can be fabricated or grown (block 408) at temperatures of approximately 200 degrees Celsius. Such reduced temperature ensures that the core layer 604 composed of a silicon material does not become damaged during the growth process of the carbon nanofibers 304.

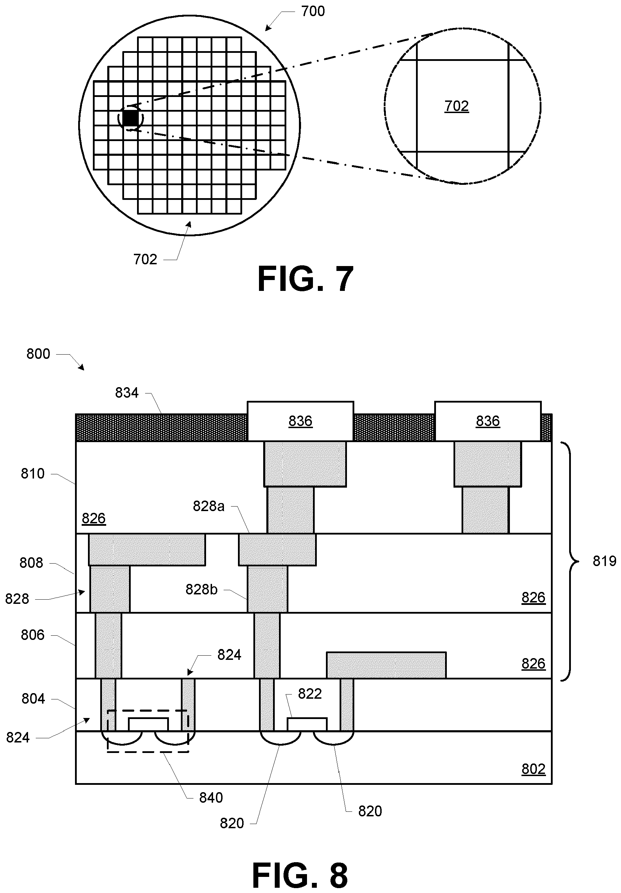

The example capacitor apparatus 202, 602 disclosed herein may be included in any suitable electronic component. FIGS. 7-10 illustrate various examples of apparatus that may include or be included in an IC package (e.g., the IC package 100 of FIG. 1) that includes the capacitor apparatus 202, 602 disclosed herein.

FIG. 7 is a top view of a wafer 700 and dies 702 that may be included in the IC package 100 of FIG. 1. The wafer 700 may be composed of semiconductor material and may include one or more dies 702 having IC structures formed on a surface of the wafer 700. Each of the dies 702 may be a repeating unit of a semiconductor product that includes any suitable IC. After the fabrication of the semiconductor product is complete, the wafer 700 may undergo a singulation process in which the dies 702 are separated from one another to provide discrete "chips" of the semiconductor product. The die 702 may include one or more transistors (e.g., some of the transistors 840 of FIG. 8, discussed below), supporting circuitry to route electrical signals to the transistors, passive components (e.g., signal traces, resistors, capacitors, or inductors), and/or any other IC components. In some examples, the wafer 700 or the die 702 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 702. For example, a memory array formed by multiple memory devices may be formed on a same die 702 as processor circuitry or other logic that is configured to store information in the memory devices or execute instructions stored in the memory array. The example IC package 100 disclosed herein may be manufactured using a die-to-wafer assembly technique in which some dies 106, 108 are attached to a wafer 700 that include others of the dies 106, 108, and the wafer 700 is subsequently singulated.

FIG. 8 is a cross-sectional side view of an IC device 800 that may be included in the example capacitor apparatus 202, 602 (e.g., in any one of the package substrate 110). One or more of the IC devices 800 may be included in one or more dies 702 (FIG. 7). The IC device 800 may be formed on a die substrate 802 (e.g., the wafer 700 of FIG. 7) and may be included in a die (e.g., the die 702 of FIG. 7). The die substrate 802 may be a semiconductor substrate composed of semiconductor material systems including, for example, n-type or p-type materials systems (or a combination of both). The die substrate 802 may include, for example, a crystalline substrate formed using a bulk silicon or a silicon-on-insulator (SOI) substructure. In some examples, the die substrate 802 may be formed using alternative materials, which may or may not be combined with silicon, that include but are not limited to germanium, indium antimonide, lead telluride, indium arsenide, indium phosphide, gallium arsenide, or gallium antimonide. Further materials classified as group II-VI, III-V, or IV may also be used to form the die substrate 802. Although a few examples of materials from which the die substrate 802 may be formed are described here, any material that may serve as a foundation for an IC device 800 may be used. The die substrate 802 may be part of a singulated die (e.g., the dies 702 of FIG. 7) or a wafer (e.g., the wafer 700 of FIG. 7).

The IC device 800 may include one or more device layers 804 disposed on the die substrate 802. The device layer 804 may include features of one or more transistors 840 (e.g., metal oxide semiconductor field-effect transistors (MOSFETs)) formed on the die substrate 802. The device layer 804 may include, for example, one or more source and/or drain (S/D) regions 820, a gate 822 to control current flow in the transistors 840 between the S/D regions 820, and one or more S/D contacts 824 to route electrical signals to/from the S/D regions 820. The transistors 840 may include additional features not depicted for the sake of clarity, such as device isolation regions, gate contacts, and the like. The transistors 840 are not limited to the type and configuration depicted in FIG. 8 and may include a wide variety of other types and configurations such as, for example, planar transistors, non-planar transistors, or a combination of both. Non-planar transistors may include FinFET transistors, such as double-gate transistors or tri-gate transistors, and wrap-around or all-around gate transistors, such as nanoribbon and nanowire transistors.

Each transistor 840 may include a gate 822 formed of at least two layers, a gate dielectric and a gate electrode. The gate dielectric may include one layer or a stack of layers. The one or more layers may include silicon oxide, silicon dioxide, silicon carbide, and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some examples, an annealing process may be carried out on the gate dielectric to improve its quality when a high-k material is used.

The gate electrode may be formed on the gate dielectric and may include at least one p-type work function metal or n-type work function metal, depending on whether the transistor 840 is to be a p-type metal oxide semiconductor (PMOS) or an n-type metal oxide semiconductor (NMOS) transistor. In some implementations, the gate electrode may consist of a stack of two or more metal layers, where one or more metal layers are work function metal layers and at least one metal layer is a fill metal layer. Further metal layers may be included for other purposes, such as a barrier layer. For a PMOS transistor, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some examples, when viewed as a cross-section of the transistor 840 along the source-channel-drain direction, the gate electrode may consist of a U-shaped structure that includes a bottom portion substantially parallel to the surface of the die substrate 802 and two sidewall portions that are substantially perpendicular to the upper or top surface of the die substrate 802. In other examples, at least one of the metal layers that form the gate electrode may simply be a planar layer that is substantially parallel to the top surface of the die substrate 802 and does not include sidewall portions substantially perpendicular to the top surface of the die substrate 802. In other examples, the gate electrode may consist of a combination of U-shaped structures and planar, non-U-shaped structures. For example, the gate electrode may consist of one or more U-shaped metal layers formed atop one or more planar, non-U-shaped layers.

In some examples, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some examples, a plurality of spacer pairs may be used; for instance, two pairs, three pairs, or four pairs of sidewall spacers may be formed on opposing sides of the gate stack.

The S/D regions 820 may be formed within the die substrate 802 adjacent to the gate 822 of each transistor 840. The S/D regions 820 may be formed using an implantation/diffusion process or an etching/deposition process, for example. In the former process, dopants such as boron, aluminum, antimony, phosphorous, or arsenic may be ion-implanted into the die substrate 802 to form the S/D regions 820. An annealing process that activates the dopants and causes them to diffuse farther into the die substrate 802 may follow the ion-implantation process. In the latter process, the die substrate 802 may first be etched to form recesses at the locations of the S/D regions 820. An epitaxial deposition process may then be carried out to fill the recesses with material that is used to fabricate the S/D regions 820. In some implementations, the S/D regions 820 may be fabricated using a silicon alloy such as silicon germanium or silicon carbide. In some examples, the epitaxially deposited silicon alloy may be doped in situ with dopants such as boron, arsenic, or phosphorous. In some examples, the S/D regions 820 may be formed using one or more alternate semiconductor materials such as germanium or a group III-V material or alloy. In further examples, one or more layers of metal and/or metal alloys may be used to form the S/D regions 820.

Electrical signals, such as power and/or input/output (I/O) signals, may be routed to and/or from the devices (e.g., transistors 840) of the device layer 804 through one or more interconnect layers disposed on the device layer 804 (illustrated in FIG. 8 as interconnect layers 806-810). For example, electrically conductive features of the device layer 804 (e.g., the gate 822 and the S/D contacts 824) may be electrically coupled with the interconnect structures 828 of the interconnect layers 806-810. The one or more interconnect layers 806-810 may form a metallization stack (also referred to as an "ILD stack") 819 of the IC device 800.

The interconnect structures 828 may be arranged within the interconnect layers 806-810 to route electrical signals according to a wide variety of designs (in particular, the arrangement is not limited to the particular configuration of interconnect structures 828 depicted in FIG. 8). Although a particular number of interconnect layers 806-810 is depicted in FIG. 8, examples of the present disclosure include IC devices having more or fewer interconnect layers than depicted.

In some examples, the interconnect structures 828 may include lines 828a and/or vias 828b filled with an electrically conductive material such as a metal. The lines 828a may be arranged to route electrical signals in a direction of a plane that is substantially parallel with a surface of the die substrate 802 upon which the device layer 804 is formed. For example, the lines 828a may route electrical signals in a direction in and out of the page from the perspective of FIG. 8. The vias 828b may be arranged to route electrical signals in a direction of a plane that is substantially perpendicular to the surface of the die substrate 802 upon which the device layer 804 is formed. In some examples, the vias 828b may electrically couple lines 828a of different interconnect layers 806-810 together.

The interconnect layers 806-810 may include a dielectric material 826 disposed between the interconnect structures 828, as shown in FIG. 8. In some examples, the dielectric material 826 disposed between the interconnect structures 828 in different ones of the interconnect layers 806-810 may have different compositions; in other examples, the composition of the dielectric material 826 between different interconnect layers 806-810 may be the same.

A first interconnect layer 806 (referred to as Metal 1 or "M1") may be formed directly on the device layer 804. In some examples, the first interconnect layer 806 may include lines 828a and/or vias 828b, as shown. The lines 828a of the first interconnect layer 806 may be coupled with contacts (e.g., the S/D contacts 824) of the device layer 804.

A second interconnect layer 808 (referred to as Metal 2 or "M2") may be formed directly on the first interconnect layer 806. In some examples, the second interconnect layer 808 may include vias 828b to couple the lines 828a of the second interconnect layer 808 with the lines 828a of the first interconnect layer 806. Although the lines 828a and the vias 828b are structurally delineated with a line within each interconnect layer (e.g., within the second interconnect layer 808) for the sake of clarity, the lines 828a and the vias 828b may be structurally and/or materially contiguous (e.g., simultaneously filled during a dual-damascene process) in some examples.

A third interconnect layer 810 (referred to as Metal 3 or "M3") (and additional interconnect layers, as desired) may be formed in succession on the second interconnect layer 808 according to similar techniques and configurations described in connection with the second interconnect layer 808 or the first interconnect layer 806. In some examples, the interconnect layers that are "higher up" in the metallization stack 819 in the IC device 800 (i.e., further away from the device layer 804) may be thicker.

The IC device 800 may include a solder resist material 834 (e.g., polyimide or similar material) and one or more conductive contacts 836 formed on the interconnect layers 806-810. In

FIG. 8, the conductive contacts 836 are illustrated as taking the form of bond pads. The conductive contacts 836 may be electrically coupled with the interconnect structures 828 and configured to route the electrical signals of the transistor(s) 840 to other external devices. For example, solder bonds may be formed on the one or more conductive contacts 836 to mechanically and/or electrically couple a chip including the IC device 800 with another component (e.g., a circuit board). The IC device 800 may include additional or alternate structures to route the electrical signals from the interconnect layers 806-810; for example, the conductive contacts 836 may include other analogous features (e.g., posts) that route the electrical signals to external components.

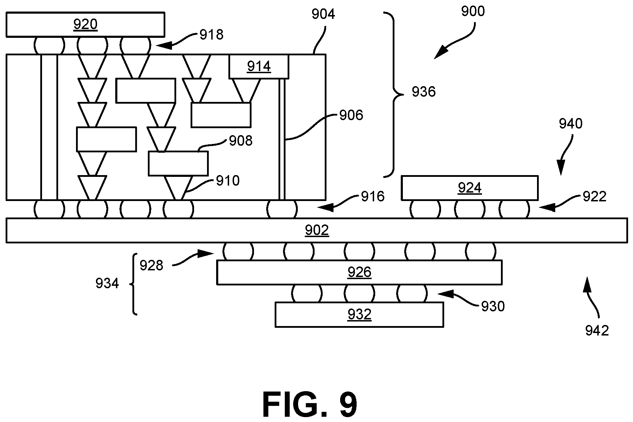

FIG. 9 is a cross-sectional side view of an IC device assembly 900 that may include the capacitor apparatus 202, 602 disclosed herein. In some examples, the IC device assembly corresponds to the capacitor apparatus 202, 602. The IC device assembly 900 includes a number of components disposed on a circuit board 902 (which may be, for example, a motherboard). The IC device assembly 900 includes components disposed on a first face 940 of the circuit board 902 and an opposing second face 942 of the circuit board 902; generally, components may be disposed on one or both faces 940 and 942. Any of the IC packages discussed below with reference to the IC device assembly 900 may take the form of the example capacitor apparatus 202, 602.

In some examples, the circuit board 902 may be a printed circuit board (PCB) including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 902. In other examples, the circuit board 902 may be a non-PCB substrate. In some examples, the circuit board 902 may be, for example, the circuit board 102 of FIG. 1.

The IC device assembly 900 illustrated in FIG. 9 includes a package-on-interposer structure 936 coupled to the first face 940 of the circuit board 902 by coupling components 916. The coupling components 916 may electrically and mechanically couple the package-on-interposer structure 936 to the circuit board 902 and may include solder balls (as shown in FIG. 9), male and female portions of a socket, an adhesive, an underfill material, and/or any other suitable electrical and/or mechanical coupling structure.

The package-on-interposer structure 936 may include an IC package 920 coupled to an interposer 904 by coupling components 918. The coupling components 918 may take any suitable form for the application, such as the forms discussed above with reference to the coupling components 916. Although a single IC package 920 is shown in FIG. 9, multiple IC packages may be coupled to the interposer 904; indeed, additional interposers may be coupled to the interposer 904. The interposer 904 may provide an intervening substrate used to bridge the circuit board 902 and the IC package 920. The IC package 920 may be or include, for example, a die (the die substrate 802 of FIG. 8), an IC device (e.g., the IC device 900 of FIG. 9), or any other suitable component. Generally, the interposer 904 may spread a connection to a wider pitch or reroute a connection to a different connection. For example, the interposer 904 may couple the IC package 920 (e.g., a die) to a set of BGA conductive contacts of the coupling components 916 for coupling to the circuit board 902. In the example illustrated in FIG. 9, the IC package 920 and the circuit board 902 are attached to opposing sides of the interposer 904; in other examples, the IC package 920 and the circuit board 902 may be attached to a same side of the interposer 904. In some examples, three or more components may be interconnected by way of the interposer 904.

In some examples, the interposer 904 may be formed as a PCB, including multiple metal layers separated from one another by layers of dielectric material and interconnected by electrically conductive vias. In some examples, the interposer 904 may be formed of an epoxy resin, a fiberglass-reinforced epoxy resin, an epoxy resin with inorganic fillers, a ceramic material, or a polymer material such as polyimide. In some examples, the interposer 904 may be formed of alternate rigid or flexible materials that may include the same materials described above for use in a semiconductor substrate, such as silicon, germanium, and other group III-V and group IV materials. The interposer 904 may include metal interconnects 908 and vias 910, including but not limited to through-silicon vias (TSVs) 906. The interposer 904 may further include embedded devices 914, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 904. The package-on-interposer structure 936 may take the form of any of the package-on-interposer structures known in the art.

The IC device assembly 900 may include an IC package 924 coupled to the first face 940 of the circuit board 902 by coupling components 922. The coupling components 922 may take the form of any of the examples discussed above with reference to the coupling components 916, and the IC package 924 may take the form of any of the examples discussed above with reference to the IC package 920.

The IC device assembly 900 illustrated in FIG. 9 includes a package-on-package structure 934 coupled to the second face 942 of the circuit board 902 by coupling components 928. The package-on-package structure 934 may include a first IC package 926 and a second IC package 932 coupled together by coupling components 930 such that the first IC package 926 is disposed between the circuit board 902 and the second IC package 932. The coupling components 928, 930 may take the form of any of the examples of the coupling components 916 discussed above, and the IC packages 926, 932 may take the form of any of the examples of the IC package 920 discussed above. The package-on-package structure 934 may be configured in accordance with any of the package-on-package structures known in the art.

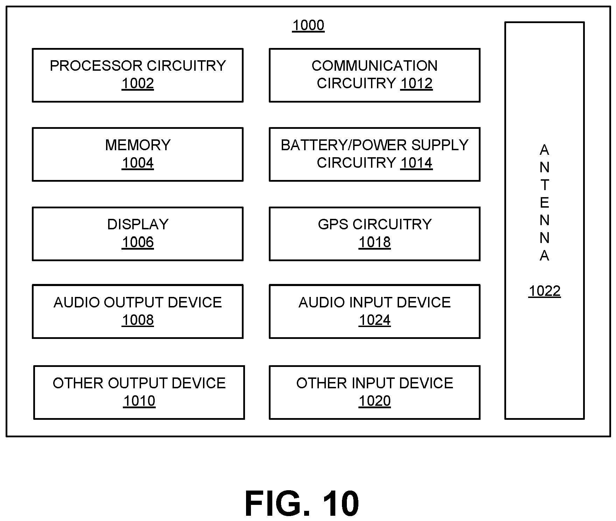

FIG. 10 is a block diagram of an example electrical device 1000 that may include one or more of the example capacitor apparatus 202, 602 of FIGS. 1-6B. For example, any suitable ones of the components of the electrical device 1000 may include one or more of the device assemblies 1000, IC devices 900, or die substrate 802 disclosed herein, and may be arranged in the example capacitor apparatus 202, 602. A number of components are illustrated in FIG. 10 as included in the electrical device 1000, but any one or more of these components may be omitted or duplicated, as suitable for the application. In some examples, some or all of the components included in the electrical device 1000 may be attached to one or more motherboards. In some examples, some or all of these components are fabricated onto a single system-on-a-chip (SoC) die.

Additionally, in various examples, the electrical device 1000 may not include one or more of the components illustrated in FIG. 10, but the electrical device 1000 may include interface circuitry for coupling to the one or more components. For example, the electrical device 1000 may not include a display 1006, but may include display interface circuitry (e.g., a connector and driver circuitry) to which a display 1006 may be coupled. In another set of examples, the electrical device 1000 may not include an audio input device 1024 (e.g., microphone) or an audio output device 1008 (e.g., a speaker, a headset, earbuds, etc.), but may include audio input or output device interface circuitry (e.g., connectors and supporting circuitry) to which an audio input device 1024 or audio output device 1008 may be coupled.

The electrical device 1000 may include a processor circuitry 1002 (e.g., one or more processing devices). As used herein, the term "processing device" or "processor" may refer to any device or portion of a device that processes electronic data from registers and/or memory to transform that electronic data into other electronic data that may be stored in registers and/or memory. The processor circuitry 1002 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The electrical device 1000 may include a memory 1004, which may itself include one or more memory devices such as volatile memory (e.g., dynamic random access memory (DRAM)), nonvolatile memory (e.g., read-only memory (ROM)), flash memory, solid state memory, and/or a hard drive. In some examples, the memory 1004 may include memory that shares a die with the processor circuitry 1002. This memory may be used as cache memory and may include embedded dynamic random access memory (eDRAM) or spin transfer torque magnetic random access memory (STT-MRAM).

In some examples, the electrical device 1000 may include a communication chip 1012 (e.g., one or more communication chips). For example, the communication chip 1012 may be configured for managing wireless communications for the transfer of data to and from the electrical device 1000. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some examples they might not.

The communication chip 1012 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2505 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 1012 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 1012 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1012 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1012 may operate in accordance with other wireless protocols in other examples. The electrical device 1000 may include an antenna 1022 to facilitate wireless communications and/or to receive other wireless communications (such as AM or FM radio transmissions).

In some examples, the communication chip 1012 may manage wired communications, such as electrical, optical, or any other suitable communication protocols (e.g., the Ethernet). As noted above, the communication chip 1012 may include multiple communication chips. For instance, a first communication chip 1012 may be dedicated to shorter-range wireless communications such as Wi-Fi or Bluetooth, and a second communication chip 1012 may be dedicated to longer-range wireless communications such as global positioning system (GPS), EDGE, GPRS, CDMA, WiMAX, LTE, EV-DO, or others. In some examples, a first communication chip 1012 may be dedicated to wireless communications, and a second communication chip 1012 may be dedicated to wired communications.

The electrical device 1000 may include battery/power circuitry 1014. The battery/power circuitry 1014 may include one or more energy storage devices (e.g., batteries or capacitors) and/or circuitry for coupling components of the electrical device 1000 to an energy source separate from the electrical device 1000 (e.g., AC line power).

The electrical device 1000 may include a display 1006 (or corresponding interface circuitry, as discussed above). The display 1006 may include any visual indicators, such as a heads-up display, a computer monitor, a projector, a touchscreen display, a liquid crystal display (LCD), a light-emitting diode display, or a flat panel display.

The electrical device 1000 may include an audio output device 1008 (or corresponding interface circuitry, as discussed above). The audio output device 1008 may include any device that generates an audible indicator, such as speakers, headsets, or earbuds.

The electrical device 1000 may include an audio input device 1024 (or corresponding interface circuitry, as discussed above). The audio input device 1024 may include any device that generates a signal representative of a sound, such as microphones, microphone arrays, or digital instruments (e.g., instruments having a musical instrument digital interface (MIDI) output).

The electrical device 1000 may include GPS circuity 1018. The GPS circuity 1018 may be in communication with a satellite-based system and may receive a location of the electrical device 1000, as known in the art.

The electrical device 1000 may include any other output device 1010 (or corresponding interface circuitry, as discussed above). Examples of the other output device 1010 may include an audio codec, a video codec, a printer, a wired or wireless transmitter for providing information to other devices, or an additional storage device.

The electrical device 1000 may include any other input device 1020 (or corresponding interface circuitry, as discussed above). Examples of the other input device 1020 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The electrical device 1000 may have any desired form factor, such as a hand-held or mobile electrical device (e.g., a cell phone, a smart phone, a mobile internet device, a music player, a tablet computer, a laptop computer, a netbook computer, an ultrabook computer, a personal digital assistant (PDA), an ultra-mobile personal computer, etc.), a desktop electrical device, a server or other networked computing component, a printer, a scanner, a monitor, a set-top box, an entertainment control unit, a vehicle control unit, a digital camera, a digital video recorder, or a wearable electrical device. In some examples, the electrical device 1000 may be any other electronic device that processes data.

The foregoing examples of the package substrates 110, 200 and 600 and/or the capacitor apparatus 202, 602 teach or suggest different features. Although each example the package substrates 110, 200 and 600 and/or the capacitor apparatus 202, 602 disclosed above has certain features, it should be understood that it is not necessary for a particular feature of one example to be used exclusively with that example. Instead, any of the features described above and/or depicted in the drawings can be combined with any of the examples, in addition to or in substitution for any of the other features of those examples. One example's features are not mutually exclusive to another example's features. Instead, the scope of this disclosure encompasses any combination of any of the features.

"including" and "comprising" (and all forms and tenses thereof) are used herein to be open ended terms. Thus, whenever a claim employs any form of "include" or "comprise" (e.g., comprises, includes, comprising, including, having, etc.) as a preamble or within a claim recitation of any kind, it is to be understood that additional elements, terms, etc., may be present without falling outside the scope of the corresponding claim or recitation. As used herein, when the phrase "at least" is used as the transition term in, for example, a preamble of a claim, it is open-ended in the same manner as the term "comprising" and "including" are open ended. The term "and/or" when used, for example, in a form such as A, B, and/or C refers to any combination or subset of A, B, C such as (1) A alone, (2) B alone, (3) C alone, (4) A with B, (5) A with C, (6) B with C, or (7) A with B and with C. As used herein in the context of describing structures, components, items, objects and/or things, the phrase "at least one of A and B" is intended to refer to implementations including any of (1) at least one A, (2) at least one B, or (3) at least one A and at least one B. Similarly, as used herein in the context of describing structures, components, items, objects and/or things, the phrase "at least one of A or B" is intended to refer to implementations including any of (1) at least one A, (2) at least one B, or (3) at least one A and at least one B. As used herein in the context of describing the performance or execution of processes, instructions, actions, activities and/or steps, the phrase "at least one of A and B" is intended to refer to implementations including any of (1) at least one A, (2) at least one B, or (3) at least one A and at least one B. Similarly, as used herein in the context of describing the performance or execution of processes, instructions, actions, activities and/or steps, the phrase "at least one of A or B" is intended to refer to implementations including any of (1) at least one A, (2) at least one B, or (3) at least one A and at least one B.

As used herein, singular references (e.g., "a", "an", "first", "second", etc.) do not exclude a plurality. The term "a" or "an" object, as used herein, refers to one or more of that object. The terms "a" (or "an"), "one or more", and "at least one" are used interchangeably herein. Furthermore, although individually listed, a plurality of means, elements or method actions may be implemented by, e.g., the same entity or object. Additionally, although individual features may be included in different examples or claims, these may possibly be combined, and the inclusion in different examples or claims does not imply that a combination of features is not feasible and/or advantageous.

From the foregoing, it will be appreciated that example systems, methods, apparatus, and articles of manufacture have been disclosed that improve the capacitance density of substrate packages. Examples disclosed herein have greater capacitance densities than similar capacitors of a same footprint due to aspect ratios of carbon nanofiber capacitor apparatus formed in-situ with a package substrate or semiconductor package.

Example methods, apparatus, systems, and articles of manufacture to provide carbon nanofiber capacitor structures for semiconductor packages are disclosed herein. Further examples and combinations thereof include the following:
Example 1 includes an apparatus having an integrated circuit package substrate, and a capacitor provided in the integrated circuit package substrate. The capacitor includes a carbon fiber array, a dielectric film positioned on the carbon fiber array, and an electrode film positioned on the dielectric film.
Example 2 includes the apparatus of example 1, further including an upper electrode layer provided on the electrode film.
Example 3 includes the apparatus of any one of examples 1-2, further including a first conductive layer provided on the integrated circuit package substrate and a second conductive layer provided on the upper electrode layer, the capacitor positioned between the first conductive layer and the second conductive layer.
Example 4 includes the apparatus of any one of examples 1-3, wherein the capacitor includes a catalyst array, a pattern provided by the catalyst array defining a pattern of the carbon fiber array.
Example 5 includes the apparatus of any one of examples 1-4, wherein the carbon fiber array includes a plurality of carbon fibers extending between the integrated circuit package substrate and the electrode film.
Example 6 includes the apparatus of any one of examples 1-5, wherein the carbon fibers include a length and a diameter, a length-to-diameter aspect ratio being 60:1, and wherein the carbon fibers have a pitch of approximately between example 1 includes 5 times the diameter to 4 times the diameter of the carbon fibers.
Example 7 includes the apparatus of any one of examples 1-6, wherein the substrate is a core layer composed of a glass substrate.
Example 8 includes the apparatus of any one of examples 1-7, wherein the apparatus is an integrated circuit package.
Example 9 includes a package substrate for an integrated circuit package, the package substrate comprising a first conductive contact, a second conductive contact, a catalyst positioned on the first conductive contact, a carbon nanofiber extending from the catalyst, a conformal layer positioned on the carbon nanofiber, and an upper electrode layer positioned on the conformal layer.
Example 10 includes the package substrate of example 9, wherein the conformal layer includes a dielectric film.
Example 11 includes the package substrate of any one of examples 9-10, further including a core layer, the first conductive contact positioned on the core layer.
Example 12 includes the package substrate of any one of examples 9-11, wherein the second conductive contact is positioned on the upper electrode layer.
Example 13 includes the package substrate of any one of examples 9-12, wherein the upper electrode layer is a fill material composed of metal.
Example 14 includes the package substrate of any one of examples 9-13, wherein the carbon nanofiber has a length of approximately between 1 micron and 25 microns and a diameter of approximately between 100 nanometers and 1000 nanometers.
Example 15 includes a method to manufacture a capacitor in a package substrate the method including providing a first conductive layer on a core layer; depositing a catalyst on the first conductive layer; fabricating a carbon nanofiber via the catalyst; depositing a dielectric film on the carbon nanofiber; depositing an electrode film on the dielectric film; forming an upper electrode on the electrode film; and providing a second conductive layer on the electrode film.
Example 16 includes the method of example 15, wherein the depositing of the dielectric film includes depositing a conformal dielectric film on the carbon nanofiber.
Example 17 includes the method of any one of examples 15-16, wherein depositing the thin dielectric film and the thin electrode film includes conformally depositing the thin dielectric film and the thin electrode film via atomic layer deposition.
Example 18 includes the method of any one of examples 15-17, wherein the forming of the upper electrode includes applying a metal fill material to the electrode film.
Example 19 includes the method of any one of examples 15-18, wherein depositing the catalyst includes depositing a plurality of catalysts on the first conductive layer and forming the carbon nanofiber includes growing a plurality of carbon nanofibers.
Example 20 includes the method of any one of examples 15-19, wherein the core layer is solid glass layer, and wherein the forming of the carbon nanofiber includes heating the catalyst and the core layer to a temperature of approximately between 300 degrees Celsius and 390 degrees Celsius.

Although certain example systems, methods, apparatus, and articles of manufacture have been disclosed herein, the scope of coverage of this patent is not limited thereto. On the contrary, this patent covers all systems, methods, apparatus, and articles of manufacture fairly falling within the scope of the claims of this patent.

The following claims are hereby incorporated into this Detailed Description by this reference, with each claim standing on its own as a separate embodiment of the present disclosure.

## Claims

1. An apparatus comprising:
an integrated circuit package substrate; and
a capacitor provided in the integrated circuit package substrate, the capacitor including:
a carbon fiber array;
a dielectric film positioned on the carbon fiber array; and
an electrode film positioned on the dielectric film.

2. The apparatus of claim 1, further including an upper electrode layer provided on the electrode film.

3. The apparatus of claim 2, further including a first conductive layer provided on the integrated circuit package substrate and a second conductive layer provided on the upper electrode layer, the capacitor positioned between the first conductive layer and the second conductive layer.

4. The apparatus of any one of claims 1-3, wherein the capacitor includes a catalyst array, a pattern provided by the catalyst array defining a pattern of the carbon fiber array.

5. The apparatus of any one of claims 1-4, wherein the carbon fiber array includes a plurality of carbon fibers extending between the integrated circuit package substrate and the electrode film.

6. The apparatus of claim 5, wherein the carbon fibers include a length and a diameter, a length-to-diameter aspect ratio being at least 50:1, and wherein the carbon fibers have a pitch of approximately between 1.5 times the diameter to 4 times the diameter of the carbon fibers.

7. The apparatus of any one of claims 1-5, wherein the integrated circuit package substrate includes a core layer composed of a glass substrate.

8. The apparatus of any one of claims 1-6, wherein the apparatus is an integrated circuit package.

9. The apparatus of any one of claims 1-7, wherein the carbon fibers have a length of approximately between 1 micron and 25 microns and a diameter of approximately between 100 nanometers and 1000 nanometers.

10. A method to manufacture a capacitor in a package substrate, the method including:
providing a first conductive layer on a core layer;
depositing a catalyst on the first conductive layer;
fabricating a carbon nanofiber via the catalyst;
depositing a dielectric film on the carbon nanofiber;
depositing an electrode film on the dielectric film;
forming an upper electrode on the electrode film; and
providing a second conductive layer on the electrode film.

11. The method of claim 10, wherein the depositing of the dielectric film includes depositing a conformal dielectric film on the carbon nanofiber.

12. The method of any one of claims 10-11, wherein depositing the dielectric film and the electrode film includes conformally depositing the dielectric film and the electrode film via atomic layer deposition.

13. The method of any one of claims 10-12, wherein the forming of the upper electrode includes applying a metal fill material to the electrode film.

14. The method of any one of claims 10-13, wherein depositing the catalyst includes depositing a plurality of catalysts on the first conductive layer and fabricating the carbon nanofiber includes growing a plurality of carbon nanofibers.

15. The method of any one of claims 10-14, wherein the core layer is solid glass layer, and wherein the forming of the carbon nanofiber includes heating the catalyst and the core layer to a temperature of approximately between 300 degrees Celsius and 390 degrees Celsius.
